# EUROPÄISCHE PATENTANMELDUNG

(11) **EP 3 450 809 A1**
(43) Veröffentlichungstag der Anmeldung: **06.03.2019**
(21) Anmeldenummer: 17188778.9
(22) Anmeldetag: 31.08.2017
(51) Int. Cl.: F16K 31/22, F16K 51/02, F16K 3/02, F16B 21/20

(54) **VERSTELLVORRICHTUNG MIT SPANNZANGENKUPPLUNG FÜR DEN VAKUUMBEREICH**

(71) Anmelder: VAT Holding AG, 9469 Haag (CH)
(72) Erfinder: ZVOKELJ, Peter, A-6973 Höchst (AT)
(74) Vertreter: Kaminski Harmann

(57) **Zusammenfassung**

Vakuumverstellvorrichtung (10) für ein in einem Prozessatmosphärenbereich bewegliches Wirkelement (15), mit einer zur Ankopplung des Wirkelements (15) ausgebildeten Kupplung (11). Die Verstellvorrichtung weist eine Antriebseinheit (12) auf, die derart ausgebildet ist und mit der Kupplung (11) zusammenwirkt, dass die Kupplung (11) von einer Normalposition, in welcher das Wirkelement (15) in angekoppeltem Zustand in einem bezüglich dessen bestimmungsgemässen Effekt im Wesentliche wirkungsfreien Zustand vorliegt, in eine Wirkposition, in welcher das Wirkelement (15) in angekoppeltem Zustand dessen bestimmungsgemässen Effekt bereitstellt, und zurück verstellbar ist. Zudem ist eine Trenneinrichtung zur Trennung des Prozessatmosphärenbereichs (P) von einem Aussenatmosphärenbereich (A) vorgesehen, wobei die Antriebseinheit (12) zumindest teilweise dem Aussenatmosphärenbereich (A) zugeordnet ist. Die Kupplung (11) weist eine Spannzange und ein mit der Spannzange zusammenwirkendes Feststellelement auf, wobei die Kupplung (11) eine Aufnahmeachse zur Aufnahme des Wirkelements (15) definiert. Die Spannzange und das Feststellelement sind zu einer derartigen relativen Positionsvariation axial entlang oder parallel der Aufnahmeachse angeordnet, dass das Feststellelement in eine Offenposition und in eine Schliessposition relativ zur Spannzange verstellbar ist. Die Kupplung (11) stellt durch das Zusammenwirken der Spannzange mit dem Feststellelement in der Offenposition einen offenen Wechselzustand und in der Schliessposition einen geschlossenen Arbeitszustand bereit.

## Beschreibung

Die Erfindung betrifft eine Vakuumverstellvorrichtung zur Bewegung und Positionierung eines mit einer Kupplung an eine Antriebseinheit ankoppelbaren Wirkelements in einer Prozessatmosphäre.

Solche für den Vakuumbereich konzipierten Verstellvorrichtungen werden beispielsweise für die Positionierung eines in einer Vakuumkammer zu bearbeitenden Substrats eingesetzt. Das Substrat wird typischerweise mittels eines Roboters in das Prozessvolumen eingebracht, wo es zur Ablage auf bestimmten Ablagepunkten in der Kammer gebracht und nach der Bearbeitung wiederum von diesem Punkten abgehoben werden muss. Diese Positionierung und Bewegung in der Prozesskammer wird mittels spezifischer Verstellvorrichtungen, so genannter Stifthubsysteme, auch Pin-Lifter genannt, realisiert.

Stifthubsysteme kommen insbesondere bei Vakuumkammersystemen im Bereich der IC-, Halbleiter-, Flat Panel- oder Substratfertigung, die in einer geschützten Atmosphäre möglichst ohne das Vorhandensein verunreinigender Partikel stattfinden muss, zum Einsatz.

Derartige Vakuumkammersysteme umfassen insbesondere mindestens eine zur Aufnahme von zu bearbeitenden oder herzustellenden Halbleiterelementen oder Substraten vorgesehene, evakuierbare Vakuumkammer, die mindestens eine Vakuumkammeröffnung besitzt, durch welche die Halbleiterelemente oder anderen Substrate in die und aus der Vakuumkammer führbar sind. Beispielsweise durchlaufen in einer Fertigungsanlage für Halbleiter-Wafer oder Flüssigkristall-Substrate die hochsensiblen Halbleiter-oder Flüssigkristall-Elemente sequentiell mehrere Prozess-Vakuumkammern, in denen die innerhalb der Prozess-Vakuumkammern befindlichen Teile mittels jeweils einer Bearbeitungsvorrichtung bearbeitet werden.

Solche Prozesskammern verfügen häufig über weitere Verstellvorrichtungen wie beispielsweise ein Transferventil, dessen Querschnitt dem Substrat und Roboter angepasst ist und durch welches das Substrat in die Vakuumkammer eingebracht und ggf. nach der vorgesehenen Bearbeitung entnommen werden kann. Alternativ kann z.B. eine weitere Verstellvorrichtung (Transferventil) vorgesehen sein, durch das das bearbeitete Substrat aus der Kammer gebracht wird.

Das Führen des Substrats, z.B. eines Wafers, erfolgt beispielsweise mit einem entsprechend ausgebildeten und gesteuerten Roboterarm, der durch die mit dem Transferventil bereitstellbare Öffnung der Prozesskammer durchführbar ist. Das Bestücken der Prozesskammer erfolgt dann mittels Greifen des Substrats mit dem Roboterarm, Bringen des Substrats in die Prozesskammer und definiertes Ablegen des Substrats in der Kammer. Das Leeren der Prozesskammer erfolgt in entsprechender Weise.

Für das Ablegen des Substrats und für die genaue Positionierung des Substrats in der Kammer muss eine verhältnismässig hohe Genauigkeit und Beweglichkeit des Substrats gewährleistet sein. Hierfür werden Stifthubsysteme eingesetzt, die eine Mehrzahl von Auflagepunkten für das Substrat und damit eine Lastverteilung (aufgrund des Eigengewichts des Substrats) über das gesamte Substrat bereitstellen.

Das Substrat wird mittels des Roboters auf den ausgefahrenen Tragstiften des Hubsystems abgelegt und durch ein Absenken der Stifte auf einem Träger, z.B. einer Potentialplatte, abgelegt. Hierzu wird der Roboterarm, der typischerweise das Substrat trägt, aus der Kammer gefahren. Die Stifte können nach dem Ablegen des Substrats weiter abgesenkt werden und liegen dann von diesem separiert vor, d.h. es besteht kein Kontakt zwischen den Stiften und dem Substrat. Nach Entfernen des Roboterarms und Schliessen (und Einbringen von Prozessgas bzw. Evakuieren) der Kammer wird der Bearbeitungsschritt durchgeführt.

Eine geringe Krafteinwirkung auf das Substrat ist insbesondere auch nach der Durchführung des Prozessschrittes in der Kammer und bei einem nachfolgenden Anheben des Substrats von hoher Bedeutung. Das Substrat weist typischerweise eine relativ glatte Oberfläche auf, die beim Ablegen mit dem Träger in Kontakt kommt und auf diesem aufliegt. Hierdurch kann beim Versuch das Substrat von dem Träger zu lösen durch einen zwischen dem Substrat und dem Träger wirkenden Unterdruck eine Art des Anhaftens resultieren - z.B. verursacht durch Lufteinschlüsse. Wird nun das Substrat zu schnell von dem Träger weggedrückt, kann es hierbei zu einem Bruch des Substrats kommen, da die Haftkräfte zumindest an gewissen Auflagepunkten nicht überwunden oder aufgelöst werden können. Zudem kann auch bei einem Zustandekommen des Kontakts zwischen den Tragstiften und dem Substrat ein dabei auftretendes Anstossen an dem Substrat zu einer unerwünschten Beanspruchung (oder Bruch) führen. Eine entsprechende Krafteinwirkung auf das Substrat ist also ein kritischer Faktor bei dem Substrathandling innerhalb der Kammer.

Gleichzeitig soll neben einer möglichst sanften und schonenden Behandlung der zu bearbeitenden Substrate eine ebenso möglichst kurze Bearbeitungszeit ermöglicht werden. Dies bedeutet, dass das Substrat möglichst schnell in die definierten Zustände - Be- und Entladeposition und Bearbeitungsposition - in der Kammer gebracht werden kann.

Zur Vermeidung von unerwünschten Stössen bei z.B. der Bearbeitung von Halbleiterwafern schlägt die US 6,481,723 B1 die Verwendung einer speziellen Stoppvorrichtung anstelle von harten Bewegungsanschlägen in einem Pin-Lifter vor. Allfällige Hartplastikanschläge sollen hier durch eine Kombination eines weicher ausgestalteten Anschlagteils und eines Hartanschlags ersetzt werden, wobei für die Bewegungsbegrenzung zunächst der Kontakt mit dem weichen Anschlagteil hergestellt wird und nachfolgend und entsprechend abgedämpft der harte Anschlag in Kontakt gebracht wird.

Die US 6,646,857 B2 schlägt eine Regelung der Hebebewegung mittels einer erfassten auftretenden Kraft vor. Die Tragstifte können hier in Abhängigkeit des erhaltenen Kraftsignals bewegt werden, so dass die Hebekraft an den Tragstiften stets entsprechende dosiert und kontrolliert auf den Wafer wirkt.

Ein weiterer Aspekt für Arbeitsprozesse unter Vakuumbedingungen und bei angelegten Potentialen ist der mögliche Einfluss durch elektrische und/oder magnetische Störquellen. In diesem Kontext ist insbesondere auch bei der Ausgestaltung eines Stifthubsystems auf mögliche Einflüsse auf den Bearbeitungsprozess zu achten. So schlägt z.B. die US 2005/0092438 A1 eine Hebevorrichtung vor, deren Tragstifte mittels eines nicht-leitenden Materials von einer Steuerplatte elektrisch getrennt werden können.

Naturgemäss liegen Teile der mit einer Vakuumverstellvorrichtung bewegten Komponenten in einem Prozessvolumen vor und sind damit ebenfalls den Einflüssen eines Bearbeitungsprozesses ausgesetzt. Dadurch können diese Teile einen verstärkten Verschleiss erfahren und bedürfen typischerweise einer regelmässigen oder bedarfsabhängigen Wartung bzw. müssen regelmässig oder bei Bedarf getauscht werden.

Bei einer als Stifthubvorrichtung ausgebildeten Vakuumverstellvorrichtung sind insbesondere die Tragstifte diesen Verschleisseinflüssen ausgesetzt und müssen entsprechend gewechselt werden.

Bei einer als Vakuumventil ausgebildeten Vakuumverstellvorrichtung ist insbesondere der Ventilverschluss (Ventilteller) von dem prozessbedingten Verschleiss betroffen. Auch diese Verschlüsse unterliegen daher solch speziellen Wartungserfordernissen.

Allgemein sind Vakuumventile zur Regelung eines Volumen-oder Massenstroms und/oder zum im Wesentlichen gasdichten Schliessen eines Fliesswegs, der durch eine in einem Ventilgehäuse ausgeformte Öffnung führt, in unterschiedlichen Ausführungsformen aus dem Stand der Technik bekannt und kommen - wie oben erwähnt - insbesondere bei Vakuumkammersystemen im Bereich der IC-, Halbleiter- oder Substratfertigung, die in einer geschützten Atmosphäre möglichst ohne das Vorhandensein verunreinigender Partikel stattfinden muss, zum Einsatz. Sowohl während des Bearbeitungsprozesses innerhalb der Prozess-Vakuumkammern, als auch während des Transports von Kammer zu Kammer müssen sich die hochsensiblen Halbleiterelemente oder Substrate stets in geschützter Atmosphäre - insbesondere in luftleerer Umgebung - befinden.

Hierfür kommen zum einen Peripherieventile zum Öffnen und Schliessen einer Gaszu- oder -abfuhr und zum anderen Transferventile zum Öffnen und Schliessen der Transferöffnungen der Vakuumkammern für das Ein- und Ausführen der Teile zum Einsatz.

Die von Halbleiterteilen durchlaufenen Vakuumventile werden aufgrund des beschriebenen Anwendungsgebiets und der damit verbundenen Dimensionierung als Vakuum-Transferventile, aufgrund ihres mehrheitlich rechteckigen Öffnungsquerschnitts auch als Rechteckventil und aufgrund ihrer üblichen Funktionsweise auch als Schieberventil, Rechteckschieber oder Transferschieberventil bezeichnet.

Peripherieventile werden insbesondere zur Steuerung oder Regelung des Gasflusses zwischen einer Vakuumkammer und einer Vakuumpumpe oder einer weiteren Vakuumkammer eingesetzt. Peripherieventile befinden sich beispielsweise innerhalb eines Rohrsystems zwischen einer Prozess-Vakuumkammer oder einer Transferkammer und einer Vakuumpumpe, der Atmosphäre oder einer weiteren Prozess-Vakuumkammer. Der Öffnungsquerschnitt derartiger Ventile, auch Pumpenventile genannt, ist in der Regel kleiner als bei einem Vakuum-Transferventil. Da Peripherieventile abhängig vom Einsatzgebiet nicht nur zum vollständigen Öffnen und Schliessen einer Öffnung, sondern auch zum Steuern oder Regeln eines Durchflusses durch kontinuierliches Verstellen des Öffnungsquerschnitts zwischen einer vollständigen Offenstellung und einer gasdichten Geschlossenstellung eingesetzt werden, werden sie auch als Regelventile bezeichnet. Ein mögliches Peripherieventil zur Steuerung oder Regelung des Gasflusses ist das Pendelventil.

Bei einem typischen Pendelventil, wie beispielsweise aus der US 6,089,537 (Olmsted) bekannt, wird in einem ersten Schritt ein in der Regel runder Ventilteller über eine in der Regel ebenfalls runde Öffnung von einer die Öffnung freigebenden Stellung in eine die Öffnung überdeckende Zwischenstellung rotatorisch geschwenkt. Im Falle eines Schieberventils, wie beispielsweise in der US 6,416,037 (Geiser) oder der US 6,056,266 (Blecha) beschrieben, ist der Ventilteller, wie auch die Öffnung, meist rechteckig ausgebildet und wird in diesem ersten Schritt linear von einer die Öffnung freigebenden Stellung in eine die Öffnung überdeckende Zwischenstellung geschoben. In dieser Zwischenstellung befindet sich der Ventilteller des Pendel-oder Schieberventils in einer beabstandeten Gegenüberlage zu dem die Öffnung umgebenden Ventilsitz. In einem zweiten Schritt wird der Abstand zwischen dem Ventilteller und dem Ventilsitz verkleinert, so dass der Ventilteller und der Ventilsitz gleichmässig aufeinander gedrückt werden und die Öffnung im Wesentlichen gasdicht verschlossen wird. Diese zweite Bewegung erfolgt vorzugsweise im Wesentlichen in eine senkrechte Richtung zum Ventilsitz. Die Abdichtung kann z.B. entweder über einen auf der Verschlussseite des Ventiltellers angeordneten Dichtungsring, der auf den die Öffnung umlaufenden Ventilsitz gepresst wird, erfolgen, oder über einen Dichtungsring auf dem Ventilsitz, gegen den die Verschlussseite des Ventiltellers gedrückt wird. Durch den in zwei Schritten erfolgenden Schliessvorgang wird der Abdichtring zwischen dem Ventilteller und dem Ventilsitz kaum Scherkräften, die den Abdichtring zerstören würden, unterworfen, da die Bewegung des Ventiltellers im zweiten Schritt im Wesentlichen geradlinig senkrecht auf den Ventilsitz stattfindet.

Unterschiedliche Dichtvorrichtungen sind aus dem Stand der Technik bekannt, beispielsweise aus der US 6,629,682 B2 (Duelli). Ein geeignetes Material für Dichtungsringe und Dichtungen bei Vakuumventilen ist beispielsweise Fluorkautschuk, auch FKM genannt, insbesondere das unter dem Handelsnamen "Viton" bekannte Fluorelastomer, sowie Perfluorkautschuk, kurz FFKM.

Aus dem Stand der Technik sind unterschiedliche Antriebssysteme zur Erzielung diese Kombination einer beim Pendelventil rotatorischen und beim Schieberventil translatorischen Bewegung des Ventiltellers parallel über die Öffnung und einer im Wesentlichen translatorischen Bewegung senkrecht auf die Öffnung bekannt, beispielsweise aus der US 6,089,537 (Olmsted) für ein Pendelventil und aus der US 6,416,037 (Geiser) für ein Schieberventil.

Das Anpressen des Ventiltellers auf den Ventilsitz muss derart erfolgen, dass sowohl die geforderte Gasdichtigkeit innerhalb des gesamten Druckbereichs sichergestellt ist, als auch eine Beschädigung des Abdichtmediums, insbesondere des Abdichtrings in Form eines O-Rings, durch zu grosse Druckbeanspruchung vermieden wird. Um dies zu gewährleisten, sehen bekannte Ventile eine in Abhängigkeit von der zwischen den beiden Ventiltellerseiten herrschenden Druckdifferenz geregelte Anpressdruckregelung des Ventiltellers vor. Besonders bei grossen Druckschwankungen oder dem Wechsel von Unterdruck auf Überdruck, oder umgekehrt, ist eine gleichmässige Kraftverteilung entlang des gesamten Umfangs des Abdichtrings jedoch nicht immer gewährleistbar. Generell wird angestrebt, den Abdichtring von Abstützkräften, die sich aus dem an das Ventil anliegenden Druck ergeben, zu entkoppeln. In der US 6,629,682 (Duelli) wird hierzu z.B. ein Vakuumventil mit einem Abdichtmedium vorgeschlagen, das sich aus einem Abdichtring und einem danebenliegenden Abstützring zusammensetzt, so dass der Abdichtring von Abstützkräften im Wesentlichen befreit ist.

Um die geforderte Gasdichtigkeit, gegebenenfalls sowohl für Über- als auch Unterdruck, zu erreichen, sehen zusätzlich oder alternativ zum zweiten Bewegungsschritt manche bekannte Pendelventile oder Schieberventile einen senkrecht zum Ventilteller verschiebbaren, die Öffnung umgebenden Ventilring vor, der zum gasdichten Schliessen des Ventils auf den Ventilteller gedrückt wird. Derartige Ventile mit relativ zum Ventilteller aktiv verschiebbaren Ventilringen sind beispielsweise aus der DE 1 264 191 B1, der DE 34 47 008 C2, der US 3,145,969 (von Zweck) und der DE 77 31 993 U bekannt. In der US 5,577,707 (Brida) wird ein Pendelventil mit einem eine Öffnung aufweisenden Ventilgehäuse und einem parallel über die Öffnung schwenkbaren Ventilteller zum Steuern eines Durchflusses durch die Öffnung beschrieben. Ein Ventilring, der die Öffnung umschliesst, ist senkrecht in Richtung zum Ventilteller mittels mehrerer Federn und Druckluftzylinder aktiv bewegbar. Eine mögliche Weiterentwicklung dieses Pendelventils wird in der US 2005/0067603 A1 (Lucas et al.) vorgeschlagen.

Den genannten Vakuumventilen ist gemein, dass jeweils ein beweglicher Ventilverschluss meist mit einem polymerbasierten Dichtmaterial mittels eines Antriebs geführt wird und zur Bereitstellung der Ventilwirkung vorgesehen ist. Der Verschluss ist dabei typischerweise zumindest teilweise dem Bearbeitungsprozess und damit erhöhtem Verschleiss ausgesetzt. Ein regelmässiges bzw. bedarfsgerechtes Tauschen des Ventilverschlusses wird entsprechend erforderlich.

In der Gesamtschau über genannte Vakuumverstellvorrichtungen, d.h. insbesondere Stifthubsysteme und Vakuumventile, ist typischerweise die Notwendigkeit eines Austauschs eines Teils der Vorrichtung in regelmässigen oder bedarfsgerechten Abständen gegeben. Die Wartung oder Erneuerung solcher Wirkelemente erfordert in aller Regel einen Stillstand oder Unterbruch von Produktionsabläufen und einen mehr oder minder massiven Eingriff in das Gesamtsystem. Für den Tausch eines Ventilverschlusses oder eines Tragstiftes ist hierbei oft das mühsame Lösen von Befestigungsvorrichtungen für das entsprechende Element erforderlich. Dies führ nicht selten zu vergleichsweise langen Stillstandzeiten und erfordert Spezialwerkzeuge für den Wartungsvorgang. Befestigungsmittel, die für eine fixe Anordnung des Wirkelements im Prozess sorgen, sind konstruktionsbedingt zudem oft nur schwer zugänglich.

Nachteilig ist dieser Umstand auch bei unerwartet auftretenden Problemen im System (z.B. Bruch eines Tragstiftes), die einen kurzfristigen und schnellen Eingriff erforderlich machen.

Es ist daher Aufgabe der vorliegenden Erfindung eine verbesserte Vakuumverstellvorrichtung bereitzustellen, bei der obige Nachteile reduziert oder vermieden werden.

Im Speziellen ist es Aufgabe der Erfindung eine verbesserte Vakuumverstellvorrichtung bereitzustellen, die eine optimierte, d.h. insbesondere schnellere und einfachere, Wartung der Vorrichtung ermöglicht.

Der Erfindung liegt weiterhin die Aufgabe zugrunde, eine entsprechend verbessert ausgestaltete Vakuumverstellvorrichtung zum optimierten Austausch von Verschleissteilen bereitzustellen.

Diese Aufgaben werden durch die Verwirklichung der kennzeichnenden Merkmale der unabhängigen Ansprüche gelöst. Merkmale, die die Erfindung in alternativer oder vorteilhafter Weise weiterbilden, sind den abhängigen Patentansprüchen zu entnehmen.

Die Erfindung beruht auf dem Ansatz eine einfachere und die Gefahr einer Partikelbildung in einem Vakuumbereich vermeidende bzw. verringernde Möglichkeit für die Wartung eines Vakuumverstellsystems, d.h. irgendeiner Art von Vorrichtung, die im Vakuumbereich bewegliche Elemente aufweist, bereitzustellen. Erfindungsgemäss soll hierfür eine spezifische Kupplung mit einer Spannzange zum Einsatz kommen.

Eine Spannzange ist typischerweise ein Spannmittel, um Werkstücke bzw. Werkzeuge mit hoher Genauigkeit, zentrisch, schnell und kraftschlüssig aufzuspannen. Spannzangen finden sich oft an Werkzeugmaschinen, jedoch können auch handbetätigte Fräser, kleine Bohrer oder Stichel mit einer Spannzange in einem Handgriff befestigt sein.

Eine Spannzange besteht typischerweise aus einer aussen kegelförmigen radial geschlitzten Hülse mit einer runden, mitunter auch quadratischen oder sechseckigen Bohrung definierter Grösse. Die Spannzange weist insbesondere eine Spannzangenaufnahme mit einem zur Spannzange passenden Innenkegel auf. Gespannt wird durch Anziehen eines Feststellelements, z.B. einer Überwurfmutter, mit dem die Spannzange in den Innenkegel der Spannzangenaufnahme gedrückt und damit verspannt wird.

Durch die Schlitzung der Spannzange kann die Bohrung in ihrem Innern gleichmäßig zusammengedrückt werden, wodurch das Werkstück oder Werkzeug kraftschlüssig festgehalten wird. Der Spannbereich einer Spannzange ist oft vergleichsweise klein.

Gemäss der Erfindung erfolgt die Betätigung der Spannzangenanordnung (Spannzange mit Feststellelement) vorzugsweise mittels einer Antriebseinheit, die die Kupplung bewegt. Wahlweise kann die Spannzange oder das Feststellelement z.B. an einen Anschlag gefahren werden und entsprechend das Feststellelement oder die Spannzange relativ zu dem so bewegungsbegrenzten Gegenstück zum Schliessen oder Öffnen der Kupplung weiter bewegt werden. Hierdurch müssen keinerlei systemfremde oder äussere Kräfte aufgebracht werden um die Kupplung in einen anderen Zustand zu versetzen.

In anderen Worten kann das Herstellen eines offenen Wechselzustands oder eines geschlossenen Arbeitszustands der Kupplung (oder ein Wechsel zwischen diesen Zuständen) vorzugsweise allein durch eine gezielte axiale Bewegung der Kupplung bereitgestellt werden, wobei im Rahmen der Gesamtbewegung zumindest eines der Elemente Spannzange und Feststellelement nur für einen Teil der gesamten Bewegungsstrecke mitbewegt wird und für die restliche Bewegungsstrecke unbewegt relativ zu dessen Gegenstück bzw. relativ zur Antriebseinheit vorliegt. In dieser Bewegungsphase, in der entweder zumindest Spannzange oder Feststellelement axial unverstellt bleibt, erfolgt durch die Weiterbewegung des anderen Elements die Zustandsänderung der Kupplung.

Die Erfindung betrifft also eine Vakuumverstellvorrichtung für ein in einem Prozessatmosphärenbereich (z.B. Vakuumbereich) bewegliches Wirkelement, z.B. ein Vakuumventil mit einem Ventilverschluss oder eine Stifthubvorrichtung mit zumindest einem Tragstift. Die Vakuumverstellvorrichtung weist eine zur Ankopplung des Wirkelements ausgebildete Kupplung und eine Antriebseinheit auf, die derart ausgebildet ist und mit der Kupplung zusammenwirkt, dass die Kupplung von einer Normalposition, in welcher das Wirkelement in angekoppeltem Zustand in einem bezüglich dessen bestimmungsgemässen Effekt im Wesentliche wirkungsfreien Zustand vorliegt, in eine Wirkposition, in welcher das Wirkelement in angekoppeltem Zustand dessen bestimmungsgemässen Effekt bereitstellt, und zurück verstellbar ist. Die Vorrichtung verfügt zudem über eine Trenneinrichtung zur Trennung des Prozessatmosphärenbereichs von einem Aussenatmosphärenbereich, wobei die Antriebseinheit zumindest teilweise dem Aussenatmosphärenbereich und die Kupplung insbesondere dem Prozessatmosphärenbereich zugeordnet ist.

Die Kupplung weist eine Spannzange und ein mit der Spannzange zusammenwirkendes Feststellelement (Spannelement) auf. Die Kupplung definiert eine Aufnahmeachse zur Aufnahme des Wirkelements oder einer Kupplungseinrichtung des Wirkelements. Die Spannzange und das Feststellelement sind zu einer derartigen relativen Positionsvariation axial entlang oder parallel der Aufnahmeachse angeordnet, dass das Feststellelement in eine Offenposition und in eine Schliessposition relativ zur Spannzange verstellbar ist, insbesondere verschiebbar ist. Die Kupplung stellt durch das Zusammenwirken der Spannzange mit dem Feststellelement in der Offenposition einen offenen Wechselzustand und in der Schliessposition einen geschlossenen Arbeitszustand bereit.

Insbesondere ist in dem offenen Wechselzustand ein durch die Spannzange definierter Innendruchmesser grösser als der durch die Spannzange in dem geschlossenen Arbeitszustand definierte Innendruchmesser.

Das Feststellelement kann z.B. als Überwurfring ausgebildet sein und entlang der zylindrisch oder kegelförmig ausgebildeten Spannzange geführt werden bzw. kann bei einem Festhalten des Feststellelements die Spannzange entsprechend aktiv geführt werden. In beiden Fällen tritt eine relative Positionsvariation ein. Eine Zustandsänderung von dem offenen Wechselzustand in den geschlossenen Arbeitszustand oder umgekehrt wird vorzugsweise durch ein Zusammenwirken von entsprechenden axialen Bereichen mit unterschiedlichen Innen- bzw. Aussenradien der beiden Komponenten realisiert.

In einer bestimmten Ausführungsform kann die Vakuumverstellvorrichtung derart ausgebildet und konfigurier sein, dass ein Wechsel zwischen der Offenposition und der Schliessposition des Feststellelements mittels einer axialen Verstellung der Kupplung durch die Antriebseinheit und einer dabei vorliegenden axialen Bewegungsbegrenzung für die Spannzange oder das Feststellelement durchführbar ist. Bei der axialen Bewegung der Kupplung wird also entweder die Spannzange oder das Feststellelement festgesetzt, damit die jeweils andere Komponente relativ dazu verschoben werden kann. Dadurch kann das Feststellelement in die Offenposition oder Schliessposition gebracht werden.

Für das Öffnen oder Schliessen der Kupplung wird hier kein Eingriff in das System bzw. die Vorrichtung von Aussen nötig. Das Wirkelement kann so einfach, d.h. weitgehend ohne Krafteinwirkung, entnommen und/oder eingesetzt werden.

Gemäss einer Ausführungsform der Erfindung kann zumindest ein Anschlagelement vorgesehen sein, wobei das zumindest eine Anschlagelement zur Interaktion mit dem Feststellelement oder der Spannzange angeordnet und ausgebildet ist. Das Anschlagelement kann entsprechend eine Begrenzung der antriebsseitig möglichen Bewegungsstrecke für das Feststellelement oder für die Spannzange bilden.

Insbesondere kann das Anschlagelement an einem Gehäuse der Vakuumverstellvorrichtung (z.B. Gehäuse der Antriebseinheit), an einer mit der Vakuumverstellvorrichtung zusammenwirkenden Prozesskammer oder an dem Wirkelement angeordnet sein oder durch das Gehäuse, die Prozesskammer oder das Wirkelement gebildet sein.

Die Antriebseinheit kann derart ausgebildet sein, dass das Feststellelement mittels Zusammenwirken mit dem zumindest einen Anschlagelement durch eine mittels der Antriebseinheit bewirkte Bewegung der Kupplung in die Offenposition und/oder Schliessposition versetzbar ist.

In einer Ausführungsform der Erfindung kann die Antriebseinheit zu einer linearen axialen Bewegung der Kupplung entlang oder parallel der Aufnahmeachse über einen bestimmten Gesamtbewegungsbereich ausgebildet sein und das zumindest eine Anschlagelement zudem zum Verstellen des Feststellelements relativ zur Spannzange im Rahmen einer Bewegung der Kupplung im Gesamtbewegungsbereich angeordnet sein.

Die Antriebseinheit kann durch deren strukturelle Ausgestaltung zwei Grenzen für eine lineare (axiale) Bewegung der Kupplung definieren. Die Einheit weist hierzu z.B. eine Führungsstange auf, die entsprechend linear über eine Strecke in diesen Grenzen verstellbar ist und an welcher die Kupplung angeordnet ist. Das Anschlagelement kann in diesen Grenzen so angeordnet sein, dass es nur in den Bewegungspfad des Feststellelements oder der Spannzange eingreift und damit nur mit einer der Komponenten der Kupplung zusammenwirkt.

Der Gesamtbewegungsbereich für die Kupplung, insbesondere für die Spannzange oder das Feststellelement, kann also durch eine erste und eine zweite Endposition begrenzt sein. In der ersten Endposition kann der offene Wechselzustand vorliegen bzw. hergestellt werden und in der zweiten Endposition der geschlossene Arbeitszustand.

Der offene Wechselzustand kann durch ein Verstellen der Kupplung bzw. der Spannzange in die erste Endposition bereitstellbar und der geschlossene Arbeitszustand durch ein Verstellen der Kupplung bzw. der Spannzange in die zweite Endposition bereitstellbar sein.

Ferner können für den Gesamtbewegungsbereich eine erste und eine zweite Aktionszone definiert sein. Die erste Endposition begrenzt die erste Aktionszone und das Feststellelement ist in der ersten Aktionszone derart verstellbar, dass die Spannzange im Wesentlichen radial kraftfrei vorliegt. Die zweite Endposition begrenzt die zweite Aktionszone und das Feststellelement ist in der zweiten Aktionszone derart verstellbar, dass die Spannzange mit einer radial nach Innen wirkenden, d.h. beispielsweise in Richtung einer Mittenachse der Spannzange, Kraft beaufschlagt ist. In den jeweiligen Aktionszonen kann also die Bereitstellung eines jeweiligen Funktionszustandes der Kupplung erfolgen, indem mittels der Antriebseinheit aktiv und gezielt eine Komponente der Kupplung relativ zur anderen Komponente (die im Rahmen dieser Bewegung positionsinvariant ist) bewegt wird.

Insbesondere sind die Normalposition und die Wirkposition der Kupplung bezüglich des Gesamtbewegungsbereichs zumindest teilweise innerhalb der ersten und/oder der zweiten Aktionszone vorgesehen.

Die Kupplung wird in einem Prozessbetrieb der Vorrichtung beispielsweise nie bis zu einer der Endpositionen versetzt, sondern wird über eine Bewegungsstrecke bewegt, die innerhalb des Gesamtbewegungsbereichs liegt und die Bereichsgrenzen nicht mit einschliesst. Nur zum Zweck eines Austauschs oder einer Wartung des Wirkelements erfolgt eine Bewegung in eine und in einer Aktionszone und damit die Betätigung des Kupplungsmechanismus. Die Kupplung wird typischerweise nicht bis einem Anschlag gefahren.

Gemäss einer Ausführungsform kann die Spannzange eine insbesondere zylindrische oder kegelförmige innere Spannzangenaufnahme aufweisen, die die Aufnahmeachse definiert. Die Dimensionierung der Spannzangenaufnahme ist insbesondere auf das aufzunehmende Wirkelement abgestimmt. Die Spannzange kann dabei als radial geschlitzte Hülse mit variierendem Aussendurchmesser entlang der Aufnahmeachse ausgebildet sein, wobei ein Innendurchmesser des Feststellelements kleiner ist als ein maximaler Aussendurchmesser der Spannzange. Spannzange und Feststellelement können weiter derart angeordnet sein, dass der Aussendurchmesser der Spannzange mit dem Innendurchmesser des Feststellelements zusammenwirkt und mittels axialen Verstellens des Feststellelements entlang der Aufnahmeachse eine radial in Richtung der Spannzangenaufnahme gerichtete Kraft auf die Spannzange erzeugbar ist.

Eine Verspannung der Spannzange kann in Zusammenwirkung mit einem eingesetzten Wirkelement eine kraftschlüssige Verbindung, d.h. ein kraftschlüssiges Festhalten des Wirkelements, bereitstellen.

Alternativ oder zusätzlich kann in einem geschlossenen Zustand der Kupplung ein Formschluss zwischen der Kupplung und dem Wirkelement bereitgestellt sein. Hierzu kann das Wirkelement beispielsweise eine ringförmig umlaufende Nut aufweisen, in die ein korrespondierender Teil der Spannzange beim Schliessen eingreift und das Festhalten des Wirkelements so bereitstellt.

Die Verstellvorrichtung ist insbesondere zur Verwendung in einem Vakuumbereich ausgebildet, wobei ein Teil der Verstellvorrichtung in dem Vakuumbereich vorliegt und bewegt wird und ein anderer Teil, vorzugsweise Teile der Antriebseinheit, ausserhalb dieses Bereichs vorliegt. Die Trenneinrichtung zur atmosphärischen Trennung der beiden Bereiche kann hierzu durch die Antriebseinheit bereitgestellt sein und z.B. durch ein Gehäuse oder einen Balg der Antriebseinheit gebildet sein.

Alternativ kann die Trenneinrichtung auch derart vorgesehen sein, dass die Kupplung teilweise oder vollständig ausserhalb des Vakuumbereichs vorliegt und bewegt wird. Die Trenneinrichtung kann z.B. mit der Kammerwand einer Prozesskammer verbunden sein.

Die Trenneinrichtung kann beispielsweise als Balg oder als Schiebedurchführung, die z.B. mit einem O-Ring abgedichtet ist, ausgebildet sein.

Die Antriebseinheit kann ferner als elektromechanischer oder pneumatischer Antrieb, insbesondere pneumatischer Antriebszylinder, ausgebildet sein.

Das Wirkelement kann als Tragstift einer Stifthubvorrichtung oder als Ventilverschluss eines Vakuumventils realisiert sein.

In einer Ausführungsform der Erfindung kann die Vakuumverstellvorrichtung eine Steuerungseinheit zur Ansteuerung der Antriebseinheit aufweisen, wobei die Steuerungseinheit eine Wartungsfunktionalität aufweist, die derart konfiguriert ist, dass bei deren Ausführung die axiale Position der Kupplung zur Bereitstellung des offenen Wechselzustands oder des geschlossenen Arbeitszustands veränderbar ist.

Es kann also eine benutzerseitig bedarfsweise ausführbare Funktion implementiert sein, die mittels der Antriebseinheit das Versetzen der Kupplung zur Bestückung oder Entnahme des Wirkelements automatisch ausführt.

Gemäss einer Ausführungsform ist die Vakuumverstellvorrichtung als Stifthubvorrichtung, insbesondere Pin-Lifter, für die Bewegung und Positionierung eines zu bearbeitenden Substrats, insbesondere eines Wafers, in dem durch eine Vakuumprozesskammer bereitstellbaren Prozessatmosphärenbereich ausgebildet und weist die Kupplung als erste Kupplung, insbesondere aus einer Mehrzahl von Kupplungen, auf.

Die Antriebseinheit stellt hier die zumindest lineare Bewegbarkeit der ersten Kupplung bereit. Die Wirkposition ist dabei durch eine Bestückungsposition zur Bestückung der Stifthubvorrichtung mit dem Substrat gebildet und die Kupplung ist zur Aufnahme eines zum Kontaktieren und Tragen des Substrats ausgestalteten und das Wirkelement bildenden Tragstifts ausgebildet. Der bestimmungsgemässe Effekt des Wirkelements (Tragstifts) kann hier als das Tragen, Heben und Absenken eines zu bearbeitenden Substrats betrachtet werden.

Die Normalposition, die durch die lineare Bewegbarkeit der ersten Kupplung hergestellt werden kann, ist insbesondere durch eine abgesenkte Position des Tragstiftes repräsentiert, bei der kein Kontakt zu dem Substrat besteht.

Die Spannzangenkupplung ermöglicht ein einfaches und schnelles Austauschen eines Tragstiftes. Ein Vorteil dieser Anordnung ist, dass für einen solchen Austausch lediglich die Kupplung in eine vordefinierte Wechselposition gefahren werden muss und kein weiterer mechanischer Eingriff an der Vorrichtung erfolgen muss. Der Stift kann dann einfach entnommen und ein neuer Stift in die geöffnete Kupplung eingesetzt werden. Insbesondere in schwer zugänglichen Prozesskammern ist eine solche Ausbildung einer Stifthubvorrichtung von Vorteil, da die Wartung ohne Spezialkenntnisse oder -werkzeug durchgeführt werden kann.

Die Stifthubvorrichtung ist insbesondere derart ausgestaltet, dass sowohl die Wirk- und Normalposition als auch der geöffnete Wechselzustand und der geschlossene Arbeitszustand mittels einer gezielten linearen Bewegung bzw. Positionierung der Kupplung bzw. einer Komponente der Kupplung hergestellt werden kann. Hierzu ist vorzugsweise allein die Bewegung bzw. Positionierung der Kupplung erforderlich, wobei für die Bereitstellung des geöffneten Wechselzustands und des geschlossenen Arbeitszustands ein Zusammenwirken mit einem relativ zur Antriebseinheit unbeweglichen Anschlag gegeben ist. Besagte gezielte lineare Bewegung bzw. Positionierung ist durch die Antriebseinheit bereitstellbar.

In einer weiteren Ausführungsform kann die Vakuumverstellvorrichtung als Vakuumventil, insbesondere Vakuumschieberventil, Pendelventil oder Monoventil, zur Regelung eines Volumen- oder Massenstroms und/oder zum gasdichten Unterbrechen eines Fliesswegs, ausgebildet sein. Die Vakuumverstellvorrichtung weist hierbei einen Ventilsitz auf, der eine eine Öffnungsachse definierende Ventilöffnung und eine die Ventilöffnung umlaufende erste Dichtfläche aufweist, und verfügt zudem über einen das Wirkelement bildenden Ventilverschluss, insbesondere Ventilteller, zur Regelung des Volumen- oder Massenstroms und/oder zur Unterbrechung des Fliesswegs (= bestimmungsgemässer Effekt), mit einer zu der ersten Dichtfläche korrespondierenden zweiten Dichtfläche.

Der Ventilverschluss ist mittels der Kupplung derart mit der Antriebseinheit gekoppelt, dass der Ventilverschluss von einer Offenposition als Normalposition, in welcher der Ventilverschluss und ein Ventilsitz des Vakuumventils relativ zueinander kontaktlos vorliegen, in eine Schliessposition als Wirkposition, in welcher über eine dazwischen liegende Dichtung ein dichtender Kontakt zwischen der ersten Dichtfläche und der zweiten Dichtfläche besteht und die Ventilöffnung dadurch gasdicht verschlossen ist, und zurück verstellbar ist. Die Kupplung ist entsprechend zur Aufnahme des Ventilverschlusses ausgebildet.

Auch hier ist ein Vorteil der Anordnung, dass der Ventilverschluss einfach in eine gelöste Entnahmeposition gebracht werden kann und mit entsprechend geringem Aufwand, d.h. insbesondere ohne ein zusätzliches Lösen von Halteschrauben, entnommen und getauscht werden kann.

Die erfindungsgemässen Vorrichtungen werden nachfolgend anhand von in den Zeichnungen schematisch dargestellten konkreten Ausführungsbeispielen rein beispielhaft näher beschrieben, wobei auch auf weitere Vorteile der Erfindung eingegangen wird. Im Einzelnen zeigen:
- Fig. 1a-c: eine Ausführungsform für eine als Stifthubvorrichtung ausgebildete Vakuumverstellvorrichtung gemäss der Erfindung in unterschiedlichen Stellungen;
- Fig. 2a-c: eine Ausführungsform für eine Spannzangenkupplung einer erfindungsgemässen Verstellvorrichtung in unterschiedlichen Zuständen; und
- Fig. 3a-b: eine weitere Ausführungsform einer erfindungsgemässen Vakuumverstellvorrichtung ausgebildet als Vakuumventil.

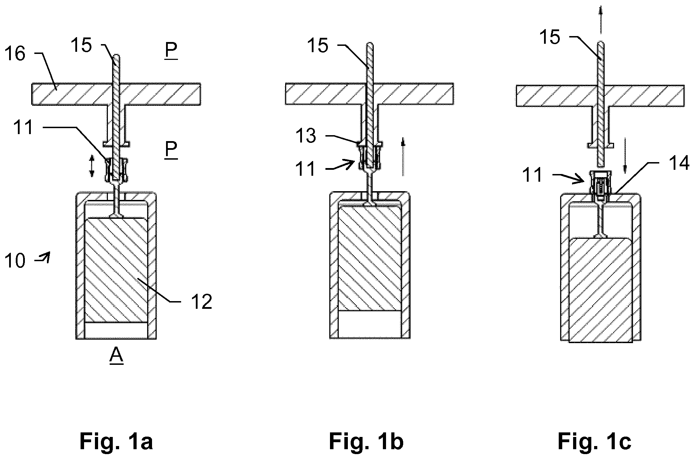

Die **Figuren 1a bis 1c** zeigen schematisch eine Ausführungsform für eine als Stifthubvorrichtung ausgebildete Vakuumverstellvorrichtung 10 in unterschiedlichen Stellungen.

Figur 1a zeigt die Stifthubvorrichtung 10 in einem Betriebs- oder Produktionszustand mit einem mittels einer Kupplung 11 mit einer Antriebseinheit 12 verbundenen Tragstift 15. Der Tragstift 15 ragt durch eine Kammerwand 16 einer Prozesskammer in das Kammerinnere. Die Antriebseinheit 15 stellt eine lineare axiale (hier: vertikale) Bewegung des Tragstiftes 15 in den Grenzen eines definierten Bewegungsbereichs bereit. Dieser Bewegungsbereich ist hier insbesondere durch die Anordnung von Antriebseineinheit 15 relativ zur Prozesskammer begrenzt.

Die Antriebseinheit wird insbesondere so angesteuert, dass der Tragstift 15 zur Bestückung der Prozesskammer in eine Aufnahmeposition versetzt wird, d.h. weit in die Prozesskammer ragt. Ein Substrat, z.B. ein Wafer kann mittels eines Roboterarms durch ein Vakuumtransferventil in eine Vakuumkammer eingebracht werden. Dort ermöglicht der Roboterarm ein Ablegen des Wafers auf dem ausgefahrenen und weiteren hier nicht gezeigten Tragestiften der Stifthubvorrichtung 10. Nach einem Auflegen des Wafers auf den Stiften werden der Roboterarm aus der Kammer geführt, das Transferventil verschlossen und die Stifte 15 mittels entsprechender Ansteuerung abgesenkt. Dies erfolgt mittels eines Antriebs- oder Hubzylinders der Antriebseinheit 12 der mit dem Stift 15 gekoppelt ist und somit eine Bewegung des Stifts 15 bereitstellt. Der Wafer kann hierdurch auf vorgesehene Trageelemente abgelegt werden.

In diesem Zustand erfolgt dann typischerweise eine geplante Bearbeitung (z.B. Beschichtung) des Wafers unter Vakuumbedingungen und insbesondere in definierter Atmosphäre (d.h. mit einem bestimmten Prozessgas). Die Kammer ist hierfür mit einer Vakuumpumpe und vorzugsweise mit einem Vakuumregelventil zur Regelung des Kammerdrucks gekoppelt (nicht gezeigt).

Nach der Bearbeitung erfolgt ein Anheben des Wafers in eine Entnahmestellung wiederum mittels der Stifthubvorrichtung 10. Mit einem zweiten Roboterarm wird in der Folge der Wafer durch ein zweites Transferventil entnommen. Alternativ kann der Prozess mit nur einem Roboterarm konzipiert sein, wobei Bestückung und Entnahme dann durch ein einzelnes Transferventil erfolgen können.

Der Tragstift 15 ist insbesondere aus elektrisch nichtleitendem, z.B. keramischen, Material und zylindrisch gefertigt. Der Tragstift 15 kann alternativ auch leitend, z.B. aus Metall, gefertigt sein.

Der Tragstift ist ferner in die Kupplung 11 eingespannt und kann in diesem eingespannten Zustand für die Durchführung der Be- und Entladung der Prozesskammer eingesetzt werden. Wie oben beschrieben, wird über die Dauer einer mehrfachen Teileproduktion aufgrund von Abnutzungs- oder Verschleisserscheinungen an dem Tragstift 15 typischerweise mindestens ein Austausch des Stiftes 15 erforderlich. Die hier gezeigte Lösung ermöglicht eine wenig zeitintensive und einfache Wartung des Stiftes 11 und ggf. der Vorrichtung 10. Hierzu ist die Kupplung 11 zwischen Tragstift 15 und Antrieb 12 vorgesehen und spezifisch ausgestaltet.

Die Kupplung 11 verfügt über eine innere Spannzange und ein äusseres Feststellelement (z.B. ein Überwurfring), das mit der Spannzange zusammenwirkt. Das Feststellelement ist relativ zur Spannzange axial entlang einer Aufnahmeachse in eine Offenposition und in eine Schliessposition verstellbar, insbesondere verschiebbar. Die Aufnahmeachse wird durch die Ersteckung der Kupplung 11 und die durch die Spannzange gebildete z.B. zylindrische oder kegelförmige innere Spannzangenaufnahme definiert. In Figur 1a ist die Kupplung 11 in einem geschlossenen, verspannten Zustand gezeigt, wobei der Tragstift 15 durch die verspannte Spannzange in der Kupplung 11 arretiert ist. Die Arretierung ist durch eine entsprechende axiale Verstellung des Feststellelements herstellbar und wieder lösbar.

Die Kupplung ist entsprechend durch das Zusammenwirken der Spannzange mit dem Feststellelement in einen offenen Wechselzustand (Offenposition des Feststellelements) und in einen geschlossenen Arbeitszustand (Schliessposition des Feststellelements) versetzbar.

Eine Betätigung des Feststellelements und damit eine Veränderung des Kupplungszustands sind durch eine gezielte Ansteuerung der Antriebseinheit durchführbar.

Ein Teil der Vakuumverstellvorrichtung 10 befindet sich in einem Prozessatmosphärenbereich P (Vakuumbereich). Dieser Bereich P ist nicht allein auf das innere Volumen der Prozesskammer beschränkt, sondern dehnt sich durch die Durchführung für den Tragstift 15 auch auf einen Bereich unterhalb der Kammer aus. Auch die Kupplung 11 befindet sich also in der Prozessatmosphäre P. Wie oben bereits ausgeführt sind innerhalb der Prozessatmosphäre P erhöhte Anforderungen an Prozessintegrität, Prozesssicherheit und Reinhaltung gestellt. Eine Vermeidung von Partikeln gilt als ein vorrangiges Kriterium. Mittels der Spannzangenkupplung 11 kann dieses Erfordernis erfüllt werden. Aufgrund des hierdurch vergleichsweise geringen Aufwands und der entsprechend reduzierten Quellen für eine Partikelgenerierung zum Austausch eines Tragstiftes - es sind beispielsweise keinerlei Schraubverbindungen zu lösen und eine Betätigung kann durch die Antriebseinheit erfolgen - kann mit dem Einsatz einer Spannzangenkupplung 11 eine signifikante Verbesserung einer typischen Verstellanordnung erreicht werden.

Die Kupplung 11 kann alternativ (nicht gezeigt) in dem Aussenatmosphärenbereich A vorliegen, wobei eine atmosphärische Trennung z.B. mittels der Kammerwand (z.B. abgedichtete Stiftdurchführung) bereitgestellt ist.

Figur 1b zeigt die Vakuumverstellvorrichtung 10, wobei die Kupplung 11 mittels der Antriebseinheit 12 an einen Anschlag 13 (in Pfeilrichtung) gefahren ist. Der Anschlag 13 stellt eine Betätigung der Kupplung 11, insbesondere des Feststellelements, bereit. Gezeigt ist die bereits hergestellte Arretierung des Stiftes 15 nach erfolgter Relativbewegung des Feststellelements. Der Tragstift 15 befindet sich also in einer geblockten Position in der Kupplung 11 und kann in diesem Zustand zur Durchführung eines Bearbeitungsprozesses verwendet werden.

Figur 1c zeigt die Kupplung 11 in geöffnetem Zustand und einen aus der Kupplung 11 gelösten bzw. in die Kupplung 11 einzusetzenden Stift 15. Zur Öffnung der Kupplung 11 wird diese in Kontakt mit einem unteren Anschlag 14 gebracht. Die axiale Beweglichkeit des Feststellelements der Kupplung 11 ist einseitig durch diesen Anschlag 14 begrenzt. Das Feststellelement wird in einem ersten Schritt in Kontakt mit dem Anschlag 14 gefahren und in einem nachfolgenden Schritt wird die innere Spannzange noch weiter in gleicher axialer Richtung versetzt. In anderen Worten, wird die Spannzange zumindest teilweise aus dem Feststellelement gezogen. Hierdurch wird eine radial nach Innen gerichtete Kraft auf die Spannzange und damit die zur Arretierung des Stiftes 15 erforderliche Kraft reduziert oder aufgelöst.

Das Umgekehrte erfolgt zur Schliessung der Kupplung 11. Das Feststellelement wird an den Anschlag 13 gefahren, insbesondere nur zum Zwecke der Kontaktherstellung (im Wesentlichen kraftlos), und die Spannzange wird dann durch eine weitergeführte axiale Bewegung in das Element geschoben, wodurch die Spannzange verspannt wird, d.h. die radial wirkende Kraft auf die Zange erzeugt bzw. vergrössert wird. Der Tragstift 15 wird noch vor dem Einschieben der Spannzange in die Kupplung 11 eingesetzt.

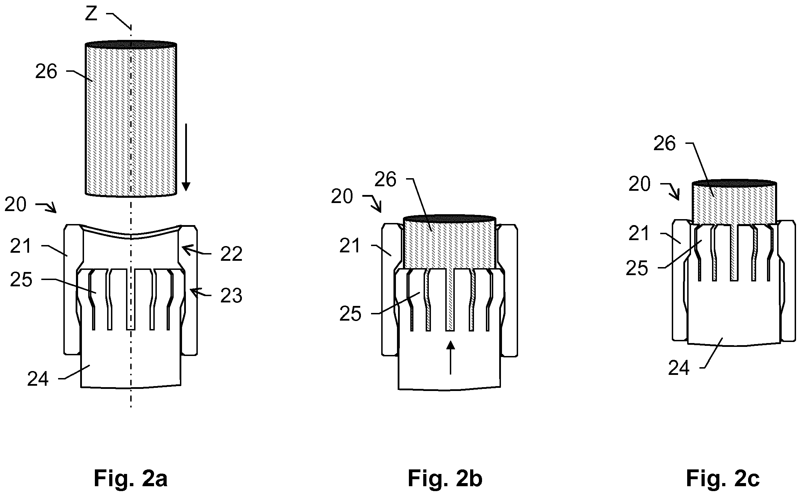

Die **Figuren 2a bis 2c** zeigen eine Ausführungsform für eine Spannzangenkupplung 20 einer erfindungsgemässen Verstellvorrichtung in unterschiedlichen Zuständen.

Mit Figur 2a ist die Kupplung 20 in einem offenen Wechselzustand ohne eine Bestückung mit einem Wirkelement (z.B. Ventilteller oder Tragstift) gezeigt. Bezugszeichen 26 bezeichnet einen Teil eines zylindrischen Ankoppelabschnitts eines Wirkelements, also jenen Teil des Elements, der in der Kupplung 20 aufgenommen und für dessen weitere Verwendung darin arretiert werden soll.

Das Feststellelement, hier als Überwurfring 21 ausgebildet, weist bezüglich dessen axialer Erstreckungen unterschiedliche Innenradien bzw. Innendurchmesser auf. In einem ersten Endbereich 22 ist der Innenradius im Vergleich zu einem Mittenbereich 23 kleiner.

Die Spannzange 24 ist bezüglich ihrer räumlichen Ausdehnung an die Dimensionierung des Feststellelements 21 angepasst. Die Spannzange 24 weist in einem oberen Hülsenbereich eine Mehrzahl von Spann- oder Klemmschenkeln 25 auf, die hier ringförmig angeordnet sind. Insbesondere ist die Spannzange 24 als geschlitzte Hülse ausgebildet. Der Aussendruchmesser der Spannzange im Bereich der Klemmschenkel 25 entspricht (ohne Vorliegen einer Kraft auf die Spannzange) im Wesentlichen dem Innendruchmesser des Überwurfrings 21 im Mittenbereich 23 oder ist zur Bereitstellung einer definierten Vorspannung etwas grösser ausgeführt.

Die Klemmschenkel 25 weisen jeweils zu einer Mittelachse hin abgewinkelte Enden auf und erzeugen dort so einen geringeren Innendruchmesser. Dieser reduzierte (kraftfreie) Innendurchmesser entspricht hier im Wesentlichen dem Durchmesser der Spannzange 24 im unteren Bereich, unterhalb der Klemmelemente 25.

Der Innendurchmesser der Kupplung 20 in dem offenen Wechselzustand, d.h. insbesondere der kleinste Innendurchmesser der Spannzange 24, und der (Aussen-) Durchmesser des zylindrischen Ankoppelabschnitts 26 sind mit einer korrespondierenden räumlichen Ausdehnung angelegt. Der Ankoppelabschnitt 26 kann so ohne erheblichen Kraftaufwand in die Kupplung 20 eingeführt werden. Es versteht sich, dass die Spannzange 24 einen geringfügig kleineren Innendurchmesser aufweisen kann, um eine gewisse Vorspannung und genaue Ausrichtbarkeit des aufgenommenen Ankoppelabschnitts 26 bereitstellen zu können.

Erfindungsgemäss kann solche eine Kupplungsausführung Teil einer Vakuumverstellvorrichtung sein. Eine Steuerung der Antriebseinheit, die eine Beweglichkeit der Kupplung 20 zumindest axial bereitstellt, ist vorzugsweise so konfiguriert, dass eine Bewegung der Spannzange 24 bei einem Anschlag des Feststellelements 21 so erfolgen kann, dass der axiale Bereich der Klemmelemente 25 nur in den Grenzen des Endbereichs 22 und des Mittenbereichs 23 verstellbar ist. Damit kann gewährleistet werden, dass die Spannzange 24 nicht aus dem Überwurfring 21 gezogen wird.

Figur 2b zeigt die Kupplung 20 ebenfalls in der Offenstellung. Der Ankoppelabschnitt 26 des Wirkelements ist in die Kupplung 20 und darin in die Spannzange 24 eingeschoben, jedoch nicht arretiert. Der Ankoppelabschnitt 26 kann so beispielsweise um dessen Ersteckungsachse gedreht werden. Die Spannzange 24 weist insbesondere an deren unterem Ende eine innere Begrenzung auf, z.B. eine Kante oder Anschlag, damit der Ankoppelabschnitt 26 mit einer bestimmten Tiefe in die Zange 24 eingesetzt werden kann. Hierdurch lässt sich eine sehr genaue Reproduzierbarkeit für die Position des Wirkelements erreichen.

Figur 2c zeigt die Kupplung 20 in einem geschlossenen Arbeitszustand. Das Feststellelement 21 ist hierzu relativ zur Spannzange 24 in eine Schliessposition versetzt. Der Endbereich 22 des Feststellelements 21 korrespondiert hierbei bezüglich dessen Position axial zumindest teilweise mit den Klemmschenkeln 25, insbesondere mit dem Bereich der Klemmschenkel 25, der einen vergrösserten Aussenradius aufweist. Aus diesem Zusammenwirken resultiert eine in Richtung der inneren Spannzangenaufnahme gerichtete Klemmkraft auf die Klemmschenkel 25.

Die Klemmkraft schafft eine Verspannung bzw. Verklemmung der Klemmschenkel 25 an den Ankoppelabschnitt 26 derart, dass der Ankoppelabschnitt 26 arretiert ist, d.h. einer vergleichsweise grossen, an dem Ankoppelabschnitt 26 ansetzenden Zugkraft widerstehen kann.

Zum Erreichen der Schliessposition (Figur 2b nach Figur 2c) wird das Feststellelement 21 insbesondere an einen oberen Positionsanschlag gefahren und die Spannzange 24 zusammen mit dem eingesetzten Ankoppelabschnitt 26 dann in das Feststellelement 21 gedrückt.

Zum Erreichen der Offenposition (Figur 2c nach Figur 2a) wird das Feststellelement 21 insbesondere an einen unteren Positionsanschlag gefahren und die Spannzange 24 zusammen mit dem eingesetzten Ankoppelabschnitt 26 dann über eine definierte Strecke aus dem Feststellelement 21 herausgezogen.

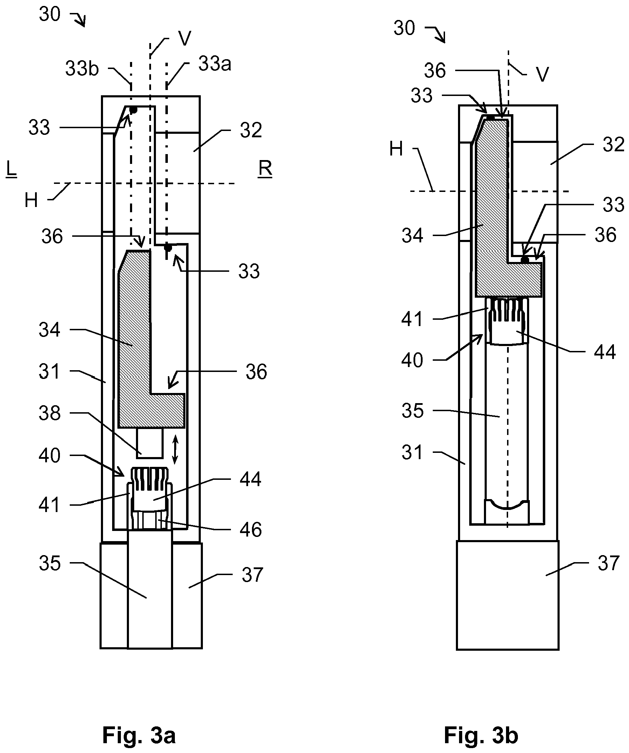

Die **Figuren 3a und 3b** zeigen schematisch eine weitere Ausführungsform einer erfindungsgemässen Vakuumverstellvorrichtung ausgebildet als Vakuumventil 30. Im Beispiel ist das Ventil 30 ausgeführt als ein so genanntes Monoventil und im Querschnitt dargestellt in einer Ventil-Offenposition (Fig. 1a) und einer Ventil-Schliessposition (Fig.1b).

Das Ventil 30 zum gasdichten Schliessen eines Fliesswegs mittels einer Linearbewegung besitzt ein Ventilgehäuse 31 mit einer Öffnung 32 für den Fliessweg, wobei die Öffnung 32 eine geometrische Öffnungsachse H entlang des Fliesswegs aufweist. Die Öffnung 32 verbindet einen ersten Gasbereich L, welcher sich in der Zeichnung links des Ventils 30 bzw. einer Trennwand (nicht dargestellt) befindet, mit einem zweiten Gasbereich R rechts davon. Eine solche Trennwand wird z.B. durch eine Kammerwand einer Vakuumkammer gebildet.

Das Verschlusselement 34 (Ventilteller) bildet das Wirkelement und ist linear entlang einer zu der Öffnungsachse H quer verlaufenden, geometrischen Verstellachse V in einer Verschlusselementebene von einer die Öffnung 32 freigebenden, geöffneten Position in eine über die Öffnung 32 linear geschobene, geschlossene Position (Fig. 3b) in eine Schliessrichtung und umgekehrt zurück in eine Öffnungsrichtung mittels einer Antriebseinheit 37 mit einem beweglichen Stellelement 35, im Beispiel eine Ventilstange, verschiebbar.

Zum Beispiel umschliesst eine (gekrümmte) erste Dichtfläche 33 die Öffnung 32 des Ventilgehäuses 31 entlang eines ersten Abschnitts in einer ersten Ebene 33a und entlang eines zweiten Abschnitts in einer zweiten Ebene 33b. Die erste Ebene und die zweite Ebene sind zueinander beabstandet, verlaufen parallel zueinander und parallel zu der Verschlusselementebene. Somit weisen der erste Abschnitt 33a und der gegenüberliegende zweite Abschnitt 33b zueinander einen geometrischen Versatz quer zu der Verstellachse V und in Richtung der Öffnungsachse H auf. Zwischen den beiden gegenüberliegenden Abschnitten 33a und 33b in dem sich entlang der Verstellachse V erstreckenden Bereich ist die Öffnung 32 angeordnet.

Das Verschlusselement 34 weist eine zur ersten Dichtfläche 33 korrespondierende zweite Dichtfläche 36 auf, welche entlang zum ersten und zweiten Abschnitt 33a, 33b korrespondierender Abschnitte verläuft.

Im gezeigten Beispiel ist ein eine Dichtung bildendes Dichtmaterial an der erste Dichtfläche 33 des Ventilsitzes vorgesehen. Alternativ oder zusätzlich kann die Dichtung an der zweiten Dichtfläche 36 des Ventilverschlusses angeordnet sein.

Die Dichtung kann beispielsweise als Polymer mittels Vulkanisation auf den Ventilsitz aufvulkanisiert sein. Alternativ kann die Dichtung z.B. als O-Ring in einer Nut des Ventilsitzes ausgeführt sein. Auch kann ein Dichtmaterial auf den Ventilsitz aufgeklebt sein und dadurch die Dichtung verkörpern. Solche Dichtungen sind selbstverständlich nicht auf das im Beispiel beschriebene Ventil 30 beschränkt, sondern auch bei den weiteren beschriebenen Ventilausführungsformen anwendbar.

Monoventile, d.h. mittels einer einzigen linearen Bewegung schliessbare Vakuumventile haben beispielsweise den Vorteil eines vergleichsweise einfachen Schliessmechanismus, z.B. verglichen mit den mittels zweier Bewegungen schliessbaren Transferventilen, die einen verhältnismässig komplex aufgebauten Antrieb erfordern. Da das Verschlusselement zudem einteilig ausgebildet sein kann, kann es hohen Beschleunigungskräften ausgesetzt werden, so dass dieses Ventil auch für Schnell- und Notverschlüsse verwendet werden kann. Das Schliessen und Dichten kann mittels einer einzigen linearen Bewegung erfolgen, so dass ein sehr schnelles Schliessen und Öffnen des Ventils 1 möglich ist.

Insbesondere liegt ein Vorteil von Monoventilen beispielsweise darin, dass die Dichtung aufgrund ihres Verlaufs beim Schliessen keiner Querbelastung in Querrichtung zur Längserstreckung der Dichtung unterliegt. Andererseits ist die Dichtung aufgrund Ihrer Quererstreckung zur Öffnungsachse H kaum in der Lage, auf das Verschlusselement 34 entlang der Öffnungsachse H auftretende Kräfte, die insbesondere bei grossem Differenzdruck auf das Verschlusselement 34 wirken können, aufzunehmen, was einen robusten Aufbau des Verschlusselements 34, dessen Antriebs und dessen Lagerung erfordert.

Das in den Figuren 3a und 3b gezeigte Vakuumventil 30 umfasst erfindungsgemäss eine Kupplung 40 mit einer Spannzange 44 und einem relativ zur Spannzange 44 axial beweglichen Spannelement 41 (Feststellelement). Das Spannelement 41 vermag durch ein Variieren der axialen, relativen Position (relativ zur Spannzange) die Kupplung 40 in einen offen Wechselzustand und einen geschlossenen Arbeitszustand zu versetzten. In Figur 3a ist der offene Wechselzustand gezeigt.

Die Kupplung 40 ist hierbei so konzipiert, dass das Spannelement 41 mit der Ventilstange 35 gekoppelt und führbar ist. Die Spannzange 44 wird passiv bewegt, d.h. die Spannzange 44 ist relativ zum Spannelement 41 bewegbar indem die Zange 44 an einem Anschlag anstösst und das Spannelement 41 weiter, über den Anschlagpunkt hinaus, bewegt wird. Hierzu ist ein innerer Anschlag 46 vorgesehen, der beispielsweise in der als Rohr ausgebildeten Stange 35 ausgebildet ist. Alternativ kann der Anschlag 46 auch aktiv axial bewegt werden und somit ein Versetzen der Spannzange 44 bewirken.

Die Spannzange 44 wird also mittel des Anschlags 44 abgestützt und das Spannelement 41 über die Zange 44 gezogen. Hierdurch wird die Kupplung 40 geöffnet und der Ventilverschluss 34 bzw. dessen Koppelzapfen 38 kann entnommen werden.

Für das Einsetzen eines neuen Ventilverschlusses 34 wird der Zapfen 38 in die geöffnete Spannzange 44 eingesteckt und der Ventilverschluss 34 insbesondere ausgerichtet. Zur Feststellung bzw. Arretierung des Ventilverschlusses 34 in der Kupplung 40 wird die Ventilstange 35 zusammen mit dem eingesetzten Verschluss 34 entlang der vertikalen Achse V nach oben, d.h. in die Ventil-Schliessposition, gefahren. Das Verschieben der Stange 35 erfolgt über einen Kontaktpunkt (Kontakt zwischen Ventilverschluss 34 und Dichtung der Dichtfläche 33) hinaus, wodurch das Spannelement 41 über die bewegungsbegrenzte Spannzange 44 geschoben und die Kupplung 40 in einen geschlossenen Arbeitszustand versetzt wird.

Mit einer solchen Wechselvorrichtung kann der Ventilteller 34 innerhalb des Prozessgasbereichs mit geringem Aufwand und einfachen Mitteln getauscht werden. Das mechanische Lösen und Ankoppeln des Ventiltellers 34 von und an der Ventilstange 35 kann massgebend durch eine gezielte Verstellung der vertikalen Achsposition der Kupplung 40 erfolgen. Ein weiterer mechanischer Eingriff (z.B. Lösen und Festdrehen von Schrauben) in das System kann also vermieden werden. Das Risiko einer unerwünschten Partikelbildung wird entsprechend reduziert. Vorzugsweise ist hierzu eine spezifische Ansteuerungssequenz für die Antriebseinheit 37 vorgesehen.

Es versteht sich, dass die gezeigte oder eine von der vorliegenden Erfindung umfasste Koppelausführung in anderen Vakuumventiltypen des Standes der Technik entsprechend eingesetzt werden kann. Vorzugsweise kann eine Anordnung zum Austausch und/oder zur Wartung eines verschleissanfälligen Ventilverschlusses zweckmässig sein. Denkbar ist eine entsprechende Anordnung einer solch partikelarmen und mittels eines Antriebs auslösbaren Spannzangenkupplung alternativ oder zusätzlich für weitere bewegliche Komponenten in einem Vakuum-Bearbeitungsprozess. Auch derartige Ausführungsformen sind von der vorliegenden Erfindung umfasst.

Es versteht sich, dass die dargestellten Figuren nur mögliche Ausführungsbeispiele schematisch darstellen. Die verschiedenen Ansätze können erfindungsgemäss ebenso miteinander sowie mit Vakuumvorrichtungen insbesondere zur Substratbearbeitung oder Vakuumventilen des Stands der Technik kombiniert werden.

## Patentansprüche

1. Vakuumverstellvorrichtung (10,30) für ein in einem Prozessatmosphärenbereich (P), insbesondere Vakuumbereich, bewegliches Wirkelement (15,34), mit
• einer zur Ankopplung des Wirkelements (15,34) ausgebildeten Kupplung (11,20,40),
• einer Antriebseinheit (12,37), die derart ausgebildet ist und mit der Kupplung (11,20,40) zusammenwirkt, dass die Kupplung (11,20,40) von
□ einer Normalposition, in welcher das Wirkelement (15,34) in angekoppeltem Zustand in einem bezüglich dessen bestimmungsgemässen Effekt im Wesentliche wirkungsfreien Zustand vorliegt, in
□ eine Wirkposition, in welcher das Wirkelement (15,34) in angekoppeltem Zustand dessen bestimmungsgemässen Effekt bereitstellt,
und zurück verstellbar ist, und
• einer Trenneinrichtung zur Trennung des Prozessatmosphärenbereichs (P) von einem Aussenatmosphärenbereich (A), wobei die Antriebseinheit (12,37) zumindest teilweise dem Aussenatmosphärenbereich (A) und die Kupplung (11,20,40) insbesondere dem Prozessatmosphärenbereich (P) zugeordnet ist,
**dadurch gekennzeichnet, dass**
die Kupplung (11,20,40) eine Spannzange (24,44) und ein mit der Spannzange (24,44) zusammenwirkendes Feststellelement (21,41) aufweist, wobei
• die Kupplung (11,20,40) eine Aufnahmeachse (Z) zur Aufnahme des Wirkelements (15,34) definiert,
• die Spannzange (24,44) und das Feststellelement (21,41) zu einer derartigen relativen Positionsvariation axial entlang oder parallel der Aufnahmeachse (Z) angeordnet sind, dass das Feststellelement (21,41) in eine Offenposition und in eine Schliessposition relativ zur Spannzange (24,44) verstellbar ist, insbesondere verschiebbar ist, und
• die Kupplung (11,20,40) durch das Zusammenwirken der Spannzange (24,44) mit dem Feststellelement (21,41) in der Offenposition einen offenen Wechselzustand und mit dem Feststellelement (21,41) in der Schliessposition einen geschlossenen Arbeitszustand bereitstellt.

2. Vakuumverstellvorrichtung (10,30) nach Anspruch 1,
**dadurch gekennzeichnet, dass**
die Vakuumverstellvorrichtung (10,30) derart ausgebildet und konfigurier ist, dass ein Wechsel zwischen der Offenposition und der Schliessposition für das Feststellelement (21,41) mittels einer axialen Verstellung der Kupplung (11,20,40) durch die Antriebseinheit und einer dabei vorliegenden axialen Bewegungsbegrenzung für die Spannzange (24,44) oder das Feststellelement (21,41) durchführbar ist.

3. Vakuumverstellvorrichtung (10,30) nach Anspruch 1 oder 2,
**dadurch gekennzeichnet, dass**
zumindest ein Anschlagelement (13,14,34,46) vorgesehen ist, wobei das zumindest eine
Anschlagelement (13,14,34,46) zur Interaktion mit dem Feststellelement (21,41) oder der Spannzange (24,44) angeordnet und ausgebildet ist.

4. Vakuumverstellvorrichtung (10,30) nach Anspruch 3,
**dadurch gekennzeichnet, dass**
das Anschlagelement (13,14,34,46)
• an einem Gehäuse (31) der Vakuumverstellvorrichtung (10,30), an einer mit der Vakuumverstellvorrichtung (10,30) zusammenwirkenden Prozesskammer (16) oder an dem Wirkelement (15,34) angeordnet ist,
oder
• durch das Gehäuse (31), die Prozesskammer oder das Wirkelement (15,34) gebildet wird.

5. Vakuumverstellvorrichtung (10,30) nach Anspruch 3 oder 4,
**dadurch gekennzeichnet, dass**
die Antriebseinheit (12,37) derart ausgebildet ist, dass das Feststellelement (21,41) mittels Zusammenwirken mit dem zumindest einen Anschlagelement (13,14,34,46) durch eine mittels der Antriebseinheit (12,37) bewirkte Bewegung der Kupplung (11,20,40) in die Offenposition und/oder Schliessposition versetzbar ist.

6. Vakuumverstellvorrichtung (10,30) nach einem der Ansprüche 3 bis 5,
**dadurch gekennzeichnet, dass**
• die Antriebseinheit (12,37) zu einer linearen axialen Bewegung der Kupplung (11,20,40) entlang oder parallel der Aufnahmeachse (Z) für einen bestimmten Gesamtbewegungsbereich ausgebildet ist und
• das zumindest eine Anschlagelement (13,14,34,46) zum Verstellen des Feststellelements (21,41) im Rahmen einer Bewegung der Kupplung (11,20,40) im Gesamtbewegungsbereich angeordnet ist.

7. Vakuumverstellvorrichtung (10,30) nach Anspruch 6,
**dadurch gekennzeichnet, dass**
• der Gesamtbewegungsbereich durch eine erste und eine zweite Endposition für die Kupplung (11,20,40), insbesondere für die Spannzange (24,44), begrenzt ist,
• in der ersten Endposition der offene Wechselzustand vorliegt und
• in der zweiten Endposition der geschlossene Arbeitszustand vorliegt,
insbesondere wobei
• der offene Wechselzustand durch ein Verstellen der Kupplung (11,20,40) bzw. der Spannzange (24,44) in die erste Endposition bereitstellbar ist und
• der geschlossene Arbeitszustand durch ein Verstellen der Kupplung (11,20,40) bzw. der Spannzange (24,44) in die zweite Endposition bereitstellbar ist.

8. Vakuumverstellvorrichtung (10,30) nach Anspruch 6 oder 7,
**dadurch gekennzeichnet, dass**
für den Gesamtbewegungsbereich eine erste und eine zweite Aktionszone definiert sind, wobei
• die erste Endposition die erste Aktionszone begrenzt und das Feststellelement (21,41) in der ersten Aktionszone derart verstellbar ist, dass die Spannzange (24,44) im Wesentlichen radial kraftfrei vorliegt, und
• die zweite Endposition die zweite Aktionszone begrenzt und das Feststellelement (21,41) in der zweiten Aktionszone derart verstellbar ist, dass die Spannzange (24,44) mit einer radialen Kraft beaufschlagt ist.

9. Vakuumverstellvorrichtung (10,30) nach Anspruch 8,
**dadurch gekennzeichnet, dass**
die Normalposition und die Wirkposition der Kupplung (11,20,40) bezüglich des Gesamtbewegungsbereichs zumindest teilweise innerhalb der ersten und/oder der zweiten Aktionszone vorgesehen sind.

10. Vakuumverstellvorrichtung (10,30) nach einem der Ansprüche 1 bis 9,
**dadurch gekennzeichnet, dass**
• die Spannzange (24,44) eine insbesondere zylindrische oder kegelförmige innere Spannzangenaufnahme aufweist, die die Aufnahmeachse (Z) definiert,
• die Spannzange (24,44) als radial geschlitzte Hülse mit variierendem Aussendurchmesser entlang der Aufnahmeachse (Z) ausgebildet ist,
• ein Innendurchmesser des Feststellelements (21,41) kleiner ist als ein maximaler Aussendurchmesser der Spannzange (24,44) und
• Spannzange (24,44) und Feststellelement (21,41) derart angeordnet sind, dass
□ der Aussendurchmesser der Spannzange (24,44) mit dem Innendurchmesser des Feststellelements (21,41) zusammenwirkt und
□ mittels Verstellen des Feststellelements (21,41) entlang der Aufnahmeachse (Z) eine radial in das Innere der Spannzange (24,44) gerichtete Kraft auf die Spannzange (24,44) erzeugbar ist.

11. Vakuumverstellvorrichtung (10,30) nach einem der Ansprüche 1 bis 10,
**dadurch gekennzeichnet, dass**
• die Trenneinrichtung durch ein Gehäuse oder einen Balg der Antriebseinheit (12,37) gebildet ist,
und/oder
• die Antriebseinheit (12,37) als pneumatischer Antriebszylinder ausgebildet ist.

12. Vakuumverstellvorrichtung (10,30) nach einem der Ansprüche 1 bis 11,
**dadurch gekennzeichnet, dass**
das Wirkelement (15,34) als Tragstift (15) oder als Ventilverschluss (34) ausgebildet ist.

13. Vakuumverstellvorrichtung (10,30) nach einem der Ansprüche 1 bis 12,
**dadurch gekennzeichnet, dass**
die Vakuumverstellvorrichtung (10,30) eine Steuerungseinheit zur Ansteuerung der Antriebseinheit (12,37) aufweist, wobei die Steuerungseinheit eine Wartungsfunktionalität aufweist, die derart konfiguriert ist, dass bei deren Ausführung die axiale Position der Kupplung (11,20,40) zur Bereitstellung des offenen Wechselzustands oder des geschlossenen Arbeitszustands veränderbar ist.

14. Vakuumverstellvorrichtung (10,30) nach einem der Ansprüche 1 bis 13,
**dadurch gekennzeichnet, dass**
die Vakuumverstellvorrichtung (10,30) als Stifthubvorrichtung (10), insbesondere Pin-Lifter, für die Bewegung und Positionierung eines zu bearbeitenden Substrats, insbesondere eines Wafers, in dem durch eine Vakuumprozesskammer bereitstellbaren Prozessatmosphärenbereich (P) ausgebildet ist und die Kupplung (11) als erste Kupplung aufweist, insbesondere aus einer Mehrzahl von Kupplungen, wobei
• die Antriebseinheit (12) die zumindest lineare Bewegbarkeit der ersten Kupplung (11) bereitstellt,
• die Wirkposition durch eine Bestückungsposition zur Bestückung der Stifthubvorrichtung mit dem Substrat gebildet ist und
• die Kupplung (11) zur Aufnahme eines zum Kontaktieren und Tragen des Substrats ausgestalteten und das Wirkelement bildenden Tragstifts (15) ausgebildet ist.

15. Vakuumverstellvorrichtung (10,30) nach einem der Ansprüche 1 bis 13,
**dadurch gekennzeichnet, dass**
die Vakuumverstellvorrichtung (10,30) als Vakuumventil (30), insbesondere Vakuumschieberventil, Pendelventil oder Monoventil, zur Regelung eines Volumen- oder Massenstroms und/oder zum gasdichten Unterbrechen eines Fliesswegs, ausgebildet ist, mit
• einem Ventilsitz, der eine eine Öffnungsachse (H) definierende Ventilöffnung (32) und eine die Ventilöffnung (32) umlaufende erste Dichtfläche (33) aufweist,
• einem das Wirkelement (15,34) bildenden Ventilverschluss (34), insbesondere Ventilteller, zur Regelung des Volumen- oder Massenstroms und/oder zur Unterbrechung des Fliesswegs, mit einer zu der ersten Dichtfläche (33) korrespondierenden zweiten Dichtfläche (36),
• der Ventilverschluss (34) mittels der Kupplung (40) derart mit der Antriebseinheit (37) gekoppelt ist, dass der Ventilverschluss (34) von
□ einer Offenposition als Normalposition, in welcher der Ventilverschluss und ein Ventilsitz des Vakuumventils (30) relativ zueinander kontaktlos vorliegen, in
□ eine Schliessposition als Wirkposition, in welcher über eine dazwischen liegende Dichtung ein dichtender Kontakt zwischen der ersten Dichtfläche (33) und der zweiten Dichtfläche (36) besteht und die Ventilöffnung (32) dadurch gasdicht verschlossen ist,
und zurück verstellbar ist, und
• die Kupplung (40) zur Aufnahme des Ventilverschlusses (34) ausgebildet ist.
